# FASCICULE DE BREVET EUROPEEN

(11) **EP 2 297 799 B1**
(45) Date de publication et mention de la délivrance du brevet: **20.03.2013**
(21) Numéro de dépôt: 09737055.5
(22) Date de dépôt: 13.07.2009
(51) Int. Cl.: H01L 41/113, H02N 2/18

(54) **DISPOSITIF PIÉZOÉLECTRIQUE AUTONOME DE GÉNÉRATION D'UNE TENSION ÉLECTRIQUE**
AUTONOME PIEZOELEKTRISCHE ANORDNUNG ZUM ERZEUGEN EINER ELEKTRISCHEN SPANNUNG
AUTONOMOUS PIEZOELECTRIC DEVICE FOR GENERATING AN ELECTRICAL VOLTAGE

(30) Priorité: 17.07.2008 FR 0854879
(43) Date de publication de la demande: 23.03.2011
(73) Titulaire: Martin, Jean-Frédéric, 38460 Cremieu (FR)
(72) Inventeur: Martin, Jean-Frédéric, 38460 Cremieu (FR)
(74) Mandataire: Palix, Stéphane
(86) Numéro de dépôt international: PCT/FR2009/051399
(87) Numéro de publication internationale: WO 2010/007309

(56) Documents cités:
- DE-A1-102006 025 963
- JP-A- 10 002 973
- JP-A- 58 204 782
- US-A1- 2008 150 396

## Description

### Domaine technique

L'invention se rattache au domaine des dispositifs générateurs électriques, utilisant la conversion d'une énergie mécanique en énergie électrique par le biais d'éléments piézo-électriques.

L'invention vise plus particulièrement une nouvelle architecture mécanique d'un tel dispositif, qui procure en particulier des avantages majeurs en termes de rendements et de mise en oeuvre.

### Techniques antérieures

De façon générale, de nombreux systèmes qui utilisent les composants électriques ou électroniques requièrent une autonomie énergétique, en particulier lorsqu'ils ne peuvent être reliés ou connectés à une source d'énergie extérieure. On peut citer, en particulier, des dispositifs mobiles, ainsi que des dispositifs ou appareils fixes, implantés dans des endroits où il est difficile, complexe, ou trop coûteux d'acheminer une ligne d'alimentation électrique.

Ainsi, de nombreux appareils intègrent des batteries d'accumulateurs ou piles, qui assurent une alimentation d'énergie électrique. Toutefois, ces batteries d'accumulateurs ont une autonomie limitée qui nécessite leur remplacement régulier.

Dans certains appareils, on a proposé d'intégrer des dispositifs permettant de générer une énergie électrique par conversion d'une énergie disponible à proximité de l'appareil. On peut ainsi citer les dispositifs photovoltaïques qui convertissent une énergie lumineuse, ainsi que les dispositifs à base d'éléments piézoélectriques qui permettent de convertir une énergie mécanique en une tension électrique consécutive à la déformation de l'élément piézoélectrique.

De nombreux dispositifs de génération d'énergie électrique par effet piézoélectrique ont déjà été proposés. De tels dispositifs intègrent généralement une lame vibrante, fixée par une de ses extrémités à un support fixe, et dont l'autre extrémité libre peut se déplacer sous l'effet d'une force mécanique qui lui est appliquée. Cette force peut par exemple provenir du mouvement d'une masselotte présente en extrémité de la lame, dans le cas de la récupération d'énergie sur un système vibrant, ou bien encore d'un dispositif mécanique extérieur qui provoque l'application ponctuelle d'une force sur l'extrémité de la lame, en provoquant donc sa mise en oscillation. Tel est par exemple le cas du dispositif décrit dans le document DE 10 2006 025 963, ou bien encore JP 10002973.

Un ou plusieurs éléments piézoélectriques sont rapportés sur une face ou les deux faces de la lame, et subissent donc des déformations en même temps que cette dernière oscille. Cette déformation provoque donc l'apparition d'une tension électrique aux bornes de l'élément piézoélectrique. Cette tension peut ensuite être redressée pour charger un composant capacitif, du type condensateur, de manière à alimenter une charge. De tels dispositifs sont par exemple décrits dans les documents US 2005/0280561, EP 0 725 452, DE 296 14 851 U, ou bien encore US 7 005 778.

Le point commun de tous ces mécanismes réside dans leur fonctionnement qui résulte de la déformation d'une poutre sensiblement rectiligne, et fixée à une ou deux de ses extrémités. Une telle conception présente de nombreux inconvénients. En effet, d'un point de vue énergétique, ces systèmes présentent des rendements relativement faibles, de l'ordre de quelques pourcents au maximum. Par rendement, on entend le rapport de l'énergie électrique fournie au composant capacitif situé en aval du composant piézoélectrique, divisée par l'énergie mécanique fournie au système.

Ces faibles rendements obligent donc généralement à multiplier les systèmes de conversion pour obtenir une énergie électrique en quantité satisfaisante, en augmentant donc le volume global du dispositif de conversion, ainsi que son coût.

Un autre inconvénient des systèmes de poutre vibrante réside dans le fait que le point d'accroche au support fixe est soumis à des contraintes mécaniques importantes, du fait du moment généré au niveau du point d'encastrement et de la propagation des vibrations dans le support.

Ces contraintes mécaniques obligent donc à assurer un encastrement robuste mécaniquement, et massique, qui augmente le coût du système, et impacte ses performances.

Un des objectifs de l'invention est d'obtenir un système qui soit à la fois simple de conception, tout en possédant un rendement nettement plus élevé que les systèmes existants, et qui conserve un coût raisonnable.

### Exposé de l'invention

L'invention concerne donc un dispositif piézoélectrique de génération d'une tension électrique. De façon connue, un tel dispositif comporte une lame vibrante présentant une portion solidaire d'un support fixe. Cette lame présente au moins une extrémité libre, qui est apte à se déplacer sous l'effet d'une force mécanique. Cette lame comporte au moins un élément piézoélectrique qui est rapporté sur une des faces de la lame. Cet élément se déforme sous l'effet des oscillations de la lame, consécutives à une impulsion mécanique appliquée sur la lame par un organe extérieur, de manière à ainsi générer une tension électrique. Ces oscillations peuvent également résulter de vibrations extérieures au système.

Conformément à l'invention, ce dispositif se caractérise en ce que la lame présente une configuration générale en V, possédant deux branches sensiblement planes, reliées par une portion de liaison courbée. C'est par cette portion de liaison que la lame est solidaire du support

Autrement dit, l'invention consiste à utiliser une lame qui ne présente pas une géométrie plane et sensiblement rectiligne comme c'était le cas dans l'Art antérieur, mais au contraire une configuration recourbée ou pliée, ou en forme de U ou de V.

Dans le cas d'un fonctionnement impulsionnel, c'est soit l'une, soit les deux branches de cette lame recourbée qui subissent l'impulsion mécanique, générant une déformation de la lame qui se transmet à la branche opposée et réciproquement. La zone de liaison entre les deux branches joue le rôle de point fixe par lequel transitent l'énergie et la quantité de mouvement qui se transfère d'une branche à l'autre. Dans le cas préféré d'un fonctionnement symétrique, avec des impulsions quasi simultanées appliquées sur les deux branches, on réduit les contraintes mécaniques au niveau du point de fixation.

Ces contraintes, et en particulier le moment, peuvent être quasi nulles dans le cas où les deux branches présentent des longueurs semblables. Toutefois, dans certains cas de figures, les branches peuvent présenter des longueurs différentes, en fonction du résultat souhaité.

En pratique, la lame courbée peut adopter une configuration dans laquelle les deux branches sont quasiment parallèles, de manière à former un U, et à tout le moins forment entre elles un angle inférieur à 60°, pour adopter une configuration en V.

Le dispositif conforme à l'invention présente un facteur de qualité mécanique élevé, c'est-à-dire supérieur à 100, pour la combinaison formée entre la lame métallique ressort et l'élément piézo-électrique qui lui est rapporté. Un tel amortissement mécanique est donc particulièrement faible, de sorte que la dissipation d'énergie par amortissement mécanique après l'application d'une impulsion est également faible.

L'extraction d'énergie via l'élément piézo-électrique intervient donc sur une durée assez longue, de l'ordre de quelques dixièmes de secondes, en fonction de la géométrie du dispositif.

L'obtention d'un facteur de qualité mécanique élevé est recherchée pour limiter l'amortissement trop fort des oscillations naturelles, qui induirait une perte de rendement du dispositif. C'est pourquoi de façon générale, le volume global de l'élément piézo-électrique en combinant donc sa surface et son épaisseur, doit être optimisé, et rester faible en rapport avec le volume équivalent de la lame.

Ainsi, l'invention peut être optimisée en jouant sur la surface que l'élément piézo-électrique occupe sur la lame, ainsi que sur son épaisseur.

Ainsi, s'agissant de la surface, on a obtenu de bons résultats lorsque l'élément piézo-électrique couvre sensiblement l'intégralité de la largeur de la lame. Dans ce cas, la longueur de l'élément piézo-électrique représente environ de 10% à 35 % de la longueur de la branche de la lame sur laquelle il est implanté. En effet, et contrairement à un préjugé, il n'est pas nécessaire de recouvrir la totalité de la longueur de la lame par du matériau piézo-électrique puisqu'on aboutit alors à des dispositifs qui sont trop massifs, et qui présentent un facteur de qualité faible par rapport à la conception de l'invention.

S'agissant de l'épaisseur de l'élément piézo-électrique, il est préférable également de privilégier des éléments piézo-électriques d'épaisseur globalement faible par rapport à la lame qui les accueille, contrairement également aux dispositifs de l'Art antérieur qui privilégient à l'inverse une épaisseur d'éléments piézo-électrique importante, ce afin d'augmenter la quantité de charges électriques produites, cependant au détriment du facteur de qualité, et donc du rendement global de la récupération

Ainsi, on a obtenu de bons résultats lorsque l'épaisseur de l'élément piézo-électrique représente entre 25 et 35 % de l'épaisseur globale de la branche qui la porte, c'est-à-dire l'épaisseur combinée de l'élément piézo-électrique et de la lame.

En d'autres termes, l'élément piézo-électrique présente une épaisseur comprise entre environ 30 et 55 % de l'épaisseur de la lame.

Bien entendu, ces mesures s'entendent pour des éléments piézo-électriques et des lames qui présentent une épaisseur uniforme, ou bien encore vis-à-vis de leur épaisseur moyenne.

Différentes variantes sont envisageables en ce qui concerne la localisation du ou des éléments piézoélectriques.

Ainsi, préférentiellement et pour les actionnements du dispositif par les deux branches, chaque branche comporte un élément piézoélectrique. Dans le cas où seule une branche reçoit une impulsion mécanique, l'élément piézoélectrique peut être disposé sur la branche qui reçoit cette impulsion. De façon générale, l'élément peut être disposé sur la face externe ou interne de cette branche, et préférentiellement du côté de la branche située à proximité de la portion de liaison courbe. Plus précisément, cet élément piézoélectrique peut être disposé dans une région de la branche qui s'étend depuis la portion de liaison courbe, jusqu'à un point situé à une distance comprise entre 20 et 50 %, et préférentiellement entre 20 et 35% de la longueur de la branche. Autrement dit, l'élément piézoélectrique est préférentiellement disposé dans la moitié de la branche située le plus près de la portion de liaison. Cette zone d'emplacement privilégiée est en particulier avantageuse pour des fonctionnements en impulsion, dans lesquels la branche subit une déformation.

Dans une autre variante du cas d'un actionnement par impulsion sur une seule branche, l'élément piézoélectrique peut être disposé sur la branche opposée, c'est-à-dire celle qui ne reçoit pas l'impulsion. Dans une autre variante, il est encore possible d'avoir des éléments piézoélectriques sur les deux branches, à savoir celle qui reçoit les impulsions et celle qui ne les reçoivent pas.

Il est également possible de combiner ces différentes variantes en disposant sur la lame vibrante plusieurs éléments piézoélectriques, situés sur les deux branches. De telles combinaisons permettent d'obtenir des rendements extrêmement intéressants, supérieurs à 25%, à comparer avec les rendements inférieurs à 3 % observés sur les systèmes de l'art antérieur. En pratique, on privilégiera pour des questions de rendement, les solutions dans lesquelles le ou les éléments piézoélectriques se trouvent au moins sur la lame recevant l'impulsion.

Avantageusement, le rapport entre la longueur d'une des branches de la lame sur son épaisseur est supérieur à 20, préférentiellement à 40, et avantageusement voisin de 75.

Ces dimensions de longueur et d'épaisseur sont mesurées dans les zones où elles sont sensiblement uniformes, et en faisant abstraction de l'épaisseur de l'élément piézo-électrique.

Un tel rapport d'élancement contribue également à l'obtention d'un facteur de qualité élevée, qui permet à l'invention d'obtenir des rendements nettement supérieurs à ceux observés à ce jour dans les dispositifs analogues.

En pratique, le dispositif peut être monté sur le support fixe de différentes manières, à savoir par collage ou soudure, ou par des moyens mécaniques. Ainsi, on peut assurer un pincement de la lame par un mécanisme approprié prenant appui dans un ou plusieurs évidements latéraux réalisés dans la lame au niveau de la zone de liaison. Il est aussi possible de prévoir une ou plusieurs fentes au niveau central de la lame, dans un sens transversal ou longitudinal, de manière à y encastrer un organe solidaire du support fixe. Il est aussi possible de combiner différents évidements latéraux et/ou centraux selon la configuration de la lame. De façon préférée, le montage peut se faire grâce à des excroissances s'étendant latéralement au niveau de la portion de liaison, et formant les points de fixation/encastrement sur le support. Un positionnement latéral permet de limiter les contraintes subies par les points d'encastrement, une fois que l'impulsion a été générée, et même pendant l'impulsion si elle a été symétrique.

On a constaté qu'une bonne récupération d'énergie dans le cas de dispositif sollicité en impulsion implique que l'énergie transmise lors de l'impulsion soit emmagasinée dans la lame en réduisant autant que possible la dissipation d'énergie et notamment par des phénomènes mécaniques. Dans la mesure où le dispositif conforme à l'invention se caractérise par une faible dissipation interne grâce à son facteur de qualité élevé, le principal mode de dissipation reste la transmission d'énergie au support fixe.

C'est pourquoi le montage de la lame sur le support fixe a une incidence forte sur le rendement obtenu. D'un point de vue pratique, on privilégiera les solutions de jonction qui assurent un bon découplage entre l'énergie emmagasinée dans les lames et le support fixe. C'est pourquoi, on cherchera à diminuer les modes de transmission de contraintes, qui induisent des déformations dans la jonction et donc des pertes d'énergie.

Ainsi, la portion de liaison entre les deux branches est autant que possible minimisée, et peut être conçue pour être soumise à une contrainte symétrique. Pendant les phases d'extension des lames, le dispositif doit être capable de restituer l'énergie mécanique, élastique accumulée en phase de compression.

En pratique, l'élément piézoélectrique peut être réalisé à partir de différents matériaux, et en particulier à base de titano zirconiate de plomb (PZT), mais également tout autre matériau piézoélectrique, et en particulier des matériaux monocristallins, tels que les alliages de nobiate de plomb-magnésium et titanate de plomb (PNM-PT). Pour optimiser le rendement, on choisira des éléments piézoélectriques qui s'étendent sur la quasi-totalité de la largeur de la lame, ladite lame étant réalisée en un matériau présentant des propriétés mécaniques en termes de résistance vive élastique autorisant une application de type ressort, ainsi que des propriétés dimensionnelles qui sont favorables à la génération d'un régime oscillant et à la propagation des vibrations. A titre d'exemple, on peut citer des aciers ayant des compositions de type « ressort » tels qu'en particulier l'acier XC 75 S, ou l'acier inoxydable X10C R Ni 18 8 (T4) écroui possédant des résistances à la rupture (Rₘ) supérieures à 1100 MPa. Il est également envisageable d'utiliser des matériaux polymériques, tel que par exemple le polysulfure de phénylène (PPS).

### Description sommaire des figures

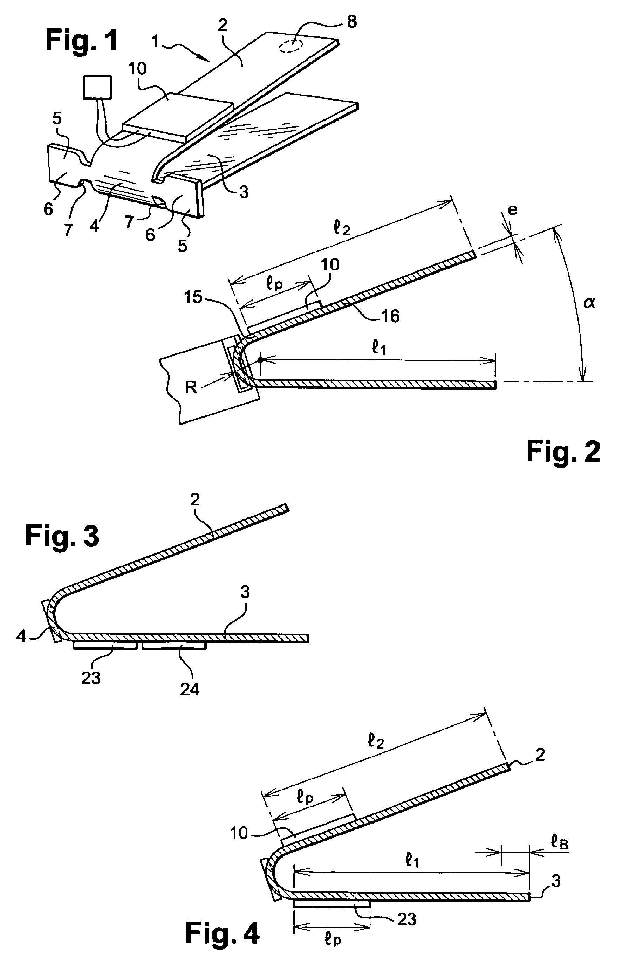

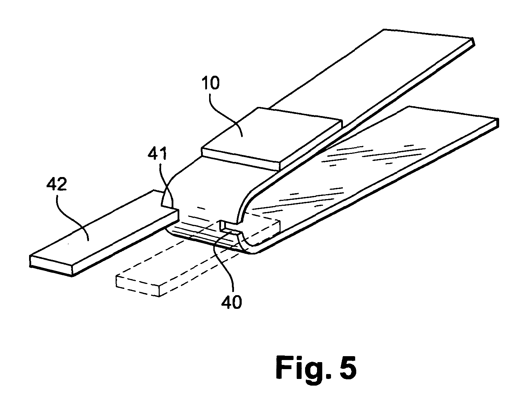

La manière de réaliser l'invention, ainsi que les avantages qui en découlent, ressortiront bien de la description des modes de réalisation qui suivent, à l'appui des figures annexées dans lesquelles :
■ la figure 1 est une vue en perspective sommaire du dispositif conforme à l'invention, réalisé selon une première variante ;
■ la figure 2 est une vue de côté du dispositif de la figure 1 ;
■ les figures 3 et 4 sont des vues de côté de deux variantes de réalisation ;
■ la figure 5 est une vue en perspective sommaire d'une variante de réalisation concernant le mode de fixation sur le support.

### Manière de réaliser l'invention

Le dispositif conforme à l'invention, tel qu'illustré à la figure 1, se présente de manière générale sous la forme d'une lame (1) à base d'un matériau rigide, courbée en forme de U ou de V. Plus précisément, la lame (1) comporte deux portions sensiblement planes (2,3) formant les branches du U, reliées par une portion de liaison courbe (4). La portion de liaison courbe (4) comporte deux excroissances obtenues par découpe et pliage lors de la fabrication de la lame. Ces excroissances (5) comprennent une plaquette de maintien (6), reliée au reste de la lame par une zone de jonction (7) de plus faible section, de manière à contrôler la quantité d'énergie transmise entre la lame et le support. Les excroissances (5) sont par exemple encastrées sur un support fixe (18).

Dans la variante de réalisation illustrée dans la figure 5, la lame (50) présente au niveau de sa portion de liaison courbe (54), deux encoches (40, 41) orientées perpendiculairement au bord de la lame.

Ces encoches (40,41) reçoivent deux plaquettes (42) emmanchées chacune en force dans l'encoche. Il est possible que les deux plaquettes soient rassemblées pour former une pièce unique en forme de U, ou de fouchette, coopérant simultanément avec les deux encoches (40,41). Ces plaquettes (42) sont destinées à être solidarisées par divers moyens au support fixe.

Ces plaquettes (42) sont avantageusement réalisées dans un matériau identique ou mécaniquement très proche de celui de la lame, afin que le comportement dynamique soit identique à celui de la lame.

Comme illustré à la figure 1, la branche (2) présente une extrémité (8) susceptible de recevoir une impulsion mécanique qui provoquera la déformation de la lame, en particulier au niveau de la zone courbée (4), puis son oscillation lorsque l'effort aura été relâché, et que la lame tendra à revenir dans sa position initiale. Il est bien entendu possible d'avoir un fonctionnement symétrique, dans lequel les deux branches (2,3) reçoivent chacune une impulsion, simultanées de préférence.

Conformément à l'invention, la lame (1) est associée à au moins un élément piézoélectrique, qui dans la forme illustrée à la figure 1, se trouve positionné sur la face externe de la branche (2). Cet élément piézoélectrique (10) est solidarisé par un procédé de collage classique, par exemple à base de colle époxydique.

En pratique, différents types de matériaux piézoélectriques peuvent être employés, en fonction des applications souhaitées, et des puissances nécessaires.

A titre d'exemple, on a obtenu des bons résultats en utilisant des matériaux piézoélectriques du type titano zirconiate de plomb. De manière plus générale, de nombreux matériaux piézoélectriques peuvent être utilisés dès lors qu'ils possèdent un coefficient de couplage k₃₁ supérieur à 0,3, et un facteur de qualité mécanique supérieur à 150.

En pratique, les dimensionnements et le positionnement des divers éléments peuvent être optimisés pour assurer un rendement maximum. Ainsi, comme illustré à la figure 2, l'angle α que forment les deux branches rectilignes (2,3) de la lame peut être inférieur à environ 45°, de manière à minimiser le couple et le basculement au niveau de la portion de liaison (4), lors de l'application d'une impulsion mécanique sur l'extrémité (8) de la branche (2). Dans une forme optimisée, cet angle peut être quasi nul. Ce couple peut être quasi nul dans le cas préférentiel où les deux branches sont actionnées presque simultanément par des impulsions d'amplitudes voisines.

Le positionnement de l'élément piézoélectrique (10) sur la branche (2) de la lame, joue également un rôle dans le niveau de performance atteint. Ainsi, on a observé qu'il est avantageux que l'élément piézoélectrique (10) soit implanté dans une région de la branche qui est située le plus proche de la zone de liaison courbe (4). Cette région de position optimale s'étend donc entre d'une part la jonction (15) de la branche (2) avec la portion courbe de liaison (4), et d'autre part, un second point (16) distant du premier point (15) d'une longueur comprise entre 10 et 50 % de la longueur L₂ de la branche (2). Ainsi, la longueur L_{P} de l'élément piézoélectrique (10) représente entre 10 et 50 % de la longueur L₂ de la branche (2).

Le rayon de courbure (R) de la zone de liaison courbe (4) est le plus faible possible. En pratique, il est de l'ordre de quelques dixièmes de millimètres à quelques millimètres, fonction en particulier de l'épaisseur (e) de la lame, qui est elle-même choisie en fonction de l'épaisseur de l'élément en matériau piézoélectrique (10).

La longueur L₁ de la branche (3) peut être choisie sensiblement identique à la longueur L₂ de la seconde branche (2), si l'on souhaite optimiser la valeur du coefficient de qualité mécanique (Qₘ) du système. Toutefois, l'utilisation d'une première branche (3) d'une longueur différente peut avoir une influence sur l'amplitude des harmoniques du signal délivré par l'élément piézoélectrique (10), et donc le rendement du dispositif.

En pratique, l'élément piézoélectrique (10), peut être réalisé par l'association en série ou en parallèle de plusieurs éléments piézoélectriques unitaires.

Comme déjà évoqué, le ou les éléments piézoélectriques peuvent être implantés à divers emplacements sur la lame, et en particulier sur l'une des branches (3), comme illustré à la figure 3. Ainsi, le ou les éléments piézoélectrique(s) (23,24) peuvent être collés sur la face externe de la branche (3), soit directement à proximité de la zone de liaison courbe (4), en ce qui concerne l'élément (23), soit plus proche du de l'extrémité en ce qui concerne l'élément piézoélectrique (24). La longueur de chacun de ces éléments et leur positionnement précis dépend de la géométrie globale de la lame et de ses modes de vibration, de manière à optimiser le rendement énergétique.

On a obtenu de bons résultats dans la configuration préférentielle illustrée à la figure 4, dans laquelle les éléments piézoélectriques sont disposés à la fois sur les deux branches de la lame, avec des actionnements simultanés et symétriques par des impulsions appliquées sur les deux branches. Un premier élément piézoélectrique (10) est disposé sur la lame (2), et un deuxième élément (23) est disposé symétriquement sur la face externe de la première lame (3), à proximité de la zone de courbure (4). Plus précisément, l'exemple particulier de réalisation décrit ci-après est donné avec des détails dimensionnés chiffrés uniquement dans le but de démontrer l'avantage de l'invention en termes de rendement. Ainsi, la lame élastique choisie est à base d'un acier ressort, du type acier inoxydable X 10 C R Ni 18 8, et présente une épaisseur (e) de 0,8 mm sur une largeur de 20 mm. La longueur L₂ de la seconde branche (2) est de 100 mm. Le rayon de la fibre neutre de la zone courbée (4) est de 3 mm. La branche (3) présente une longueur de 103 mm, et l'ensemble est tenu au niveau de la portion courbe de liaison par un support maintenu à la main. Les éléments piézoélectriques utilisés sont disposés en extrémité de leurs branches respectives, à proximité de la zone courbée (4). Les éléments piézoélectriques utilisés sont du type céramique PZT. Ces éléments sont utilisés par paires, et présentent chacun une largeur de 10 mm correspondant à la largeur de la lame, une longueur de 20 mm et une épaisseur de 0,3 mm. Leur direction de polarisation est parallèle à leur épaisseur. On peut calculer le rendement du dispositif, comme étant le rapport l'énergie électrique recueillie en sortie des éléments piézoélectriques après redressement et stockage dans un condensateur, divisée par l'énergie mécanique fournie au système. Plus précisément, l'énergie mécanique fournie au système correspond à une force d'amplitude (F) appliquée sur l'extrémité (8) de la branche libre pour provoquer un déplacement d'une course (f) de. Dans un essai avec une course de 6 mm, cette énergie mécanique mesurée est de 5,04 mJ. L'énergie électrique fournie par les éléments piézoélectriques se retrouve stockée dans une capacité formée par un condensateur de 4,7 µF, après redressement par un pont de diodes standard. La tension mesurée est voisine de 25 Volts, de sorte que le rendement correspondant est voisin de 29 %. D'autres valeurs de capacité peuvent être choisies, en fonction des contraintes électriques du dispositif, en particulier pour éviter d'avoir des tensions trop élevées.

Bien entendu, cet exemple n'est donné qu'à titre illustratif, et ne limite en aucun cas la portée de l'invention, qui peut au contraire être déclinée de manière très large tout en respectant les principes de l'invention évoqués ci-dessus.

Un tel dispositif présente de multiples avantages parmi lesquels on peut citer :
■ un couplage électromécanique k supérieur à l'état de l'art, pour une quantité de matériau piézoélectrique limitée
■ un facteur de qualité mécanique défini à la conception, par exemple supérieur à l'ordre de la centaine pour la récupération d'énergie en impulsion;
■ l'utilisation de matériaux piézoélectriques de type courant, utilisables qui plus est en quantité réduite, avec une réduction de coût correspondante ;
■ l'utilisation de matériaux couramment disponibles pour la réalisation de la lame vibrante ;
■ un procédé de fabrication simple, conduisant à un dispositif de bonne fiabilité ;
■ un rendement très important, en comparaison avec les systèmes existant ;
■ une durée de vie estimée supérieure à plusieurs dizaines d'années.
■ un système de récupération écologique et durable
■ une transmission d'énergie au niveau du point d'encastrement qui est minimisée.

### Applications industrielles

Un tel dispositif peut être utilisé de manière très large comme source d'alimentation en énergie électrique en remplacement d'accumulateurs, de piles, pour des applications de réseaux de capteurs sans fil ou pour toute application nécessitant une source d'énergie autonome, en bénéficiant d'une longue durée de vie.

On peut notamment citer les applications à des appareils de mesure des paramètres physiques dans des industries de procédé du type pétrochimie ou pharmacie. On peut mentionner les applications particulières à des capteurs de température, de pression ou de débit, et en particulier dans les circuits de distribution d'eau ou de gaz. D'autres applications concernent des appareils électriques du type interrupteurs électriques, sonnettes sans fil ou dispositifs de détection d'ouverture. Dans des versions miniaturisées, l'invention peut également être employée pour l'alimentation des systèmes micro-électro-mécaniques (MEMS).

## Revendications

1. Dispositif piézoélectrique de génération de tension électrique, comportant une lame vibrante (1) présentant une portion solidaire d'un support fixe (18), et au moins une extrémité libre (8), apte à se déplacer sous l'effet d'une force mécanique impulsionnelle (F), au moins un élément piézoélectrique (10) étant rapporté sur une face de la lame (1) pour se déformer sous l'effet des oscillations de la lame consécutives à ladite force, et ainsi générer une tension électrique, où la lame (1) présente une configuration générale en V, possédant deux branches (2,3) sensiblement planes, reliées par une portion de liaison courbée (4), qui est solidaire du support, **caractérisé en ce que** ladite portion de liaison (4) comporte des excroissances (5) s'étendant latéralement et formant des points de fixation sur le support fixé (18).

2. Dispositif selon la revendication 1, **caractérisé en ce que** les deux branches sont sensiblement parallèles.

3. Dispositif selon la revendication 1, **caractérisé en ce que** les deux branches (2,3) forment entre elles un angle inférieur à 60°.

4. Dispositif selon la revendication 1, **caractérisé en ce que** l'élément piézoélectrique (10) est disposé sur la face interne et/ou externe de l'une et/ou l'autre branché (2,3).

5. Dispositif selon la revendication 4, **caractérisé en ce que** l'élément piézoélectrique (10) est dispose l'une et/ou l'autre branche, dans une zone s'étendant de la portion de liaison jusqu'à un point situé à une distance comprise entre 10 et 50%, préférentiellement entre 20 et 35% de la longueur de la branche

6. Dispositif selon la revendication 1, **caractérisé en ce qu'**il comporte plusieurs éléments piézoélectriques(10, 23, 24), disposés sur l'une et/ou l'autre branche.

7. Dispositif selon la revendication 1, **caractérisé en ce que** l'élément piézoélectrique (10) s'étend sur la quasi-totalité de la largeur de la lame (1).

8. Dispositif selon la revendication 1, **caractérisé en ce que** les deux branches (2,3) présentent des longueurs (L₁,L₂) sensiblement égales.

9. Dispositif selon la revendication 1, **caractérisé en ce que** l'élément piézo-électrique occupe une surface comprise entre 10 et 35 % de la branche sur laquelle elle est implantée.

10. Dispositif selon la revendication 1, **caractérisé en ce que** l'épaisseur de l'élement piézo-électrique représente entre 30 et 55 % de l'épaisseur de la lame

11. Dispositif selon la revendication 1, **caractérisé en ce que** le rapport entre la longueur d'une des branches sur son épaisseur est supérieure a 20, préférentiellement à 40, et avantageusement voisin de 75.

## Claims

1. Piezoelectric device for generating an electrical voltage, comprising a vibrating plate (1) having a portion integral with a fixed support (18) and at least one free end (8) capable of moving under effect of a mechanical pulse (F), at least one piezoelectric element (10) being attached to one face of the plate (1) so as to deform under effect of oscillations of the plate that result from said mechanical pulse, thus generating an electrical voltage, wherein the plate (1) has a V-shaped general configuration and comprises two substantially plane branches (2, 3) joined by a curved linking portion (4) integral with the support, **characterized in that** the linking portion (4) comprises protrusions (5) that extend laterally and form fixing points on fixed support (18).

2. Device as claimed in claim 1, **characterized in that** the two branches are substantially parallel.

3. Device as claimed in claim 1, **characterized in that** the two branches (2, 3) form an angle of less than 60° relative to each other.

4. Device as claimed in claim 1, **characterized in that** piezoelectric element (10) is located on the inner face and/or outer face of either branch (2, 3).

5. Device as claimed in claim 4, **characterized in that** piezoelectric element (10) is located on either branch in an area which extends from the curved linking portion to a point located at a distance equal to 10 to 50% and preferably 20 to 35% of the length of the branch.

6. Device as claimed in claim 1, **characterized in that** it comprises several piezoelectric elements (10, 23, 24) located on either branch.

7. Device as claimed in claim 1, **characterized in that** piezoelectric element (10) extends over virtually the entire width of plate (1).

8. Device as claimed in claim 1, **characterised in that** the two branches (2, 3) are of substantially equal length (L₁,L₂).

9. Device as claimed in claim 1, **characterised in that** the piezoelectric element takes up a surface area of between 10 and 35% of the branch on which it is mounted.

10. Device as claimed in claim 1, **characterised in that** the thickness of the piezoelectric element represents 30 to 55% of the thickness of the plate.

11. Device as claimed in claim 1, **characterised in that** the ratio of the length of one of the branches of the plate to its thickness exceeds 20, preferably 40 and, advantageously, is around 75.

## Patentansprüche

1. Piezoelektrische Anordnung zum Erzeugen einer elektrischen Spannung, die folgendes besitzt: eine vibrierende Zunge (1), die einen Abschnitt aufweist, der mit einer feststehenden Halterung (18) fest verbunden ist, und mindestens ein freies Ende (8), das sich unter der Wirkung einer mechanischen Impulskraft (F) verschieben kann, mindestens ein piezoelektrisches Element (10), das auf einer Seite der Zunge (1) aufgesetzt ist, um sich unter der Wirkung von aufeinanderfolgenden Schwingungen der Zunge auf die Kraft zu verformen, und somit eine elektrische Spannung zu erzeugen, wobei die Zunge (1) eine allgemeine V-förmige Konfiguration mit zwei, im wesentlichen ebenen Schenkeln (2, 3) aufweist, die durch einen gebogenen Verbindungsabschnitt (4), der fest mit der Halterung verbunden ist, miteinander verbunden sind, **dadurch gekennzeichnet, dass** der Verbindungsabschnitt (4) Vorsprünge (5) besitzt, die sich seitlich erstrecken, und an der feststehenden Halterung (18) Befestigungspunkte bilden.

2. Anordnung nach Anspruch 1, **dadurch gekennzeichnet, dass** die beiden Schenkel im Wesentlichen parallel verlaufen.

3. Anordnung nach Anspruch 1, **dadurch gekennzeichnet, dass** die beiden Schenkel (2, 3) untereinander einen Winkel von weniger als 60° bilden.

4. Anordnung nach Anspruch 1, **dadurch gekennzeichnet, dass** das piezoelektrische Element (10) an der Innenseite und/oder an der Außenseite des einen und/oder des anderen Schenkels (2, 3) angeordnet ist.

5. Anordnung nach Anspruch 4, **dadurch gekennzeichnet, dass** das piezoelektrische Element (10) an dem einen und/oder anderen Schenkel in einem Bereich angeordnet ist, der sich von dem Verbindungsabschnitt bis zu einem Punkt erstreckt, der in einem Abstand zwischen 10 und 50%, vorzugsweise zwischen 20 und 35%, der Länge des Schenkels angeordnet ist.

6. Anordnung nach Anspruch 1, **dadurch gekennzeichnet, dass** sie mehrere piezoelektrische Elemente (10, 23, 24) aufweist, die an dem einen und/oder anderen Schenkel angeordnet sind.

7. Anordnung nach Anspruch 1, **dadurch gekennzeichnet, dass** sich das piezoelektrische Element (10) fast über die gesamte Breite der Zunge (1) erstreckt.

8. Anordnung nach Anspruch 1, **dadurch gekennzeichnet, dass** die beiden Schenkel (2, 3) im wesentlichen dieselbe Länge (L₁, L₂) aufweisen.

9. Anordnung nach Anspruch 1, **dadurch gekennzeichnet, dass** das piezoelektrische Element eine Fläche zwischen 10 und 35% des Schenkels, an dem es angebracht ist, einnimmt.

10. Anordnung nach Anspruch 1, **dadurch gekennzeichnet, dass** die Stärke des piezoelektrischen Elementes zwischen 30 und 55% der Stärke der Zunge ausmacht.

11. Anordnung nach Anspruch 1, **dadurch gekennzeichnet, dass** das Verhältnis zwischen der Länge eines der Schenkel zu seiner Stärke mehr als 20, vorzugsweise mehr als 40 und vorteilhafterweise fast 75, beträgt.
